# EUROPEAN PATENT SPECIFICATION

(11) **EP 2 355 199 B1**
(45) Date of publication and mention of the grant of the patent: **05.07.2017**
(21) Application number: 10000927.3
(22) Date of filing: 29.01.2010
(51) Int. Cl.: H01L 51/52, H01L 51/56, H01L 51/00, H01L 27/32

(54) **A method for producing an organic light emitting device**
Verfahren zur Herstellung einer organischen lichtemittierenden Vorrichtung
Procédé de production de dispositif électroluminescent organique

(43) Date of publication of application: 10.08.2011
(73) Proprietor: Novaled GmbH, 01307 Dresden (DE)
(72) Inventor: Werner, Ansgar, 01277 Dresden (DE); Blochwitz-Nimoth, Jan, 01097 Dresden (DE); Lessmann, Rudolf, 40591 Düsseldorf (DE)
(74) Representative: Bittner, Thomas L.

(56) References cited:
- EP-A2- 0 949 696
- EP-A2- 1 388 894
- US-A1- 2006 152 833
- US-A1- 2007 295 400
- US-A1- 2008 224 606
- US-A1- 2010 019 660
- US-B2- 7 049 757

## Description

The invention relates to technologies in the field of large area organic light emitting devices, especially large area organic light emitting diodes (OLED).

### Background of the invention

Large area organic light emitting devices have two problems due to the fact that even very power efficient OLEDs made on large areas require large current supply: uniformity and current distribution. Large area organic light emitting devices require large current handling and distribution. Due to the limited conductivity of the transparent electrode (usually the ITO anode) large and position dependent voltage drops occur, which lead to brightness nonuniformity over the organic light emitting device area. These uniformities are even larger when very low voltage (steep IV-curve) OLEDs are used.

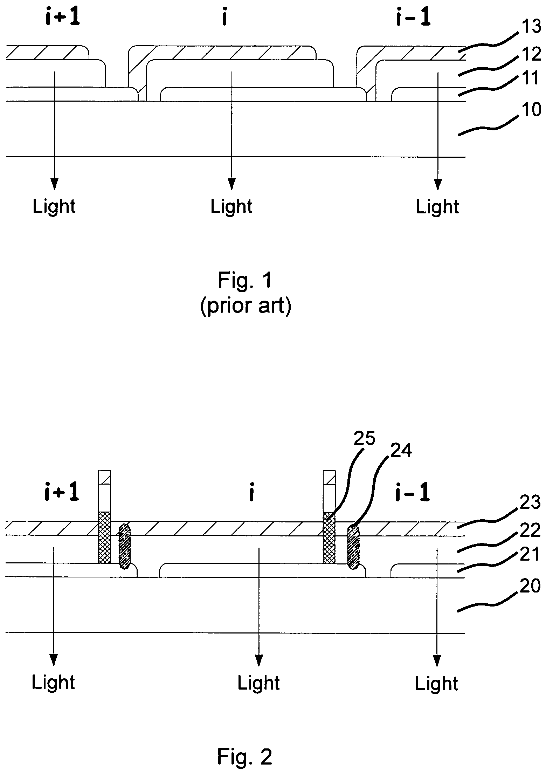

In the document US 7,049,757 it is disclosed to subdivide the large area of the organic light emitting device into sub-areas (individual OLEDs) and connect the sub-areas (partially) in series of e.g. N OLEDs (see Fig. 1). The voltage that needs to be applied to this series of N OLEDs is then N times the single OLED voltage, and the current flowing through the N OLEDs is only 1/N of the current flow over this area. However, in order to realize this series connection, a connection of the cathode of the iₜₕ OLED (i=1...N-1) to the anode of the i+1 OLED is necessary. The anodes are usually on the bottom side of the OLED (hence directly on the substrate), whereas the cathode are located on the top side of the OLED. In order to make this cathode (i) to anode (i+1) connection the uniform organic light emitting device (organic layer part) area has to be separated into appropriate sub-areas and the uniform top cathode area has to be separated into appropriate sub-areas. The layer forming the bottom electrodes also has to be separated into sub-areas. This is done by patterning the bottom layer (typically ITO), and by two mask steps, which in addition require fine alignment of two deposition masks to the substrate during the manufacturing process (see Fig. 1).

N is the total number of OLEDs in one string (column) of OLEDs electrically connected in series. A practicable upper limit for N is about 300.

The known process is complex and expensive. The alignment accuracy of the deposition mask defines the non-light emitting and visible gap between the OLEDs. Alternatively, if no fine masking is available, the gap between the OLEDs will be very large (in the range of 1 mm and above) and will destroy the uniform appearance of OLEDs, one key advantage of OLEDs vs. other large area lighting technologies.

The document US 2007/295400 A1 relates to an organic component produced as a roll in a continuous production method.

Document US 2010/019660 A1 describes a method of manufacturing an organic light emitting display.

The document EP 1 388 894 A2 relates to an apparatus including a series of organic light emitting diodes.

Document EP 0 949 696 A2 describes an organic electroluminescent device.

The document US 2006/152833 A1 relates to a method for preparing a plurality of electrically connected organic devices.

In the document US 7 049 757 B2 relates to a light emitting devices comprising a plurality of organic light emitting diodes.

Document US 2008/0224606 A1 discloses an organic electroluminescent light emitting device, in which a plurality of divided light emitting segments are connected in series. If electrical connection between a conductor part and a counter electrode generated by molding is insufficient, a method as post-treatment after molding may be applied. For example, a method for irradiating a laser onto the conductor part from a transparent electrode side or a counterpart electrode side (laser repair method) may be applied.

### Summary of the invention

It is the object of the invention to provide an improved method for producing an organic light emitting device.

The object is solved by a method for producing an organic light emitting device according to claim 1. Advantageous developments of the invention are disclosed in dependent claims.

The method provided, in one embodiment, allows for deposition of the organic layers without using a deposition shadow mask, since they 'break' (or get interrupted) at the non-conductive separator. The same holds for the top electrode. If the top electrode is a cathode, the cathode also interrupts at the non-conductive separator. The inter electrode connection provides the electrical connection between the cathode and the anode of adjacent light emitting organic diodes of the series connection. The same process and design works naturally similar if anode and cathode are exchanged (inverted OLED).

The organic layers can be deposited by any known method. Preferably, the organic layers are deposited by vacuum thermal evaporation (VTE). Another preferred method is OVPD (organic vapor phase deposition). Methods for casting organic material semiconductors from solution can also be used. Examples of such methods are drop casting, blade coating, stamp coating, spin coating, slot die coating, and spray coating. Optionally, non-patterned deposition by ink-jet can also be used.

The series connection can be made without the use of shadow mask. Also no laser ablation is necessary between the steps of depositing the organic layers, the top electrode, and the optional encapsulation. The bottom electrode and the separator can be, for example, made by lithography or other process, not requiring vacuum or inert atmosphere.

In a preferred embodiment, the organic light emitting diodes are free of any other conducting layer in direct contact with the bottom conducting layer. However, conducting layers may be provided on the borders of the whole device, which conducting layers provide external electrical connection.

The inter electrode connection which may also referred to as top-electrode-bottom-electrode connection is an electrical connection provided between the top-electrode of one organic light emitting diode to the bottom electrode of an adjacent organic light emitting diode. The inter electrode connection provides the electrical series connection.

The inter electrode connection is formed by a laser process, namely the irradiation of light into a connection area in which the inter electrode connection is to be formed. By the laser process laser generated material, for example, may be a molten material, a re-solidified material.
The inter electrode connection can be recognized by its typical shape formed by the high energy of the laser.

The laser power is such that it does not ablate the layers forming the electrodes. Therefore it is preferably that the laser power is lower than the power used for ablation. It is further preferably that the power of the laser is between 1 to 15 W, more preferably between 5 to 8 W, for an infrared laser with a wavelength between 800 to 10µm; for laser with shorter wavelengths in the range of 300 to 800 nm, it is preferred that the power is between 200 mW and 3 W, more preferably from 200 mW to 1W, even more preferably from 200 to 500 mW.

It is preferred that the laser emission is between 300 and 550 nm, especially in the range between 300 and 450 nm; in these ranges, the absorption of the metal layer is stronger, and it is easier to promote a heating. Any laser can be used, preferred ones are tripled or quadrupled Nd lasers, excimer lasers, or semiconducting lasers.

Non limiting examples of such short wavelength lasers are InGaN blue-violet laser, tripled Nd:YAG, XeF excimer layer.

Optionally, the laser used for the inter electrode connection has a wavelength from 500 to 1500 µm. Exemplary lasers are Nd lasers operating in their main wavelength which is typically in the range of 1020-1050 nm, however other bands as well as the double frequency can be used. Examples of such lasers are Nd:YAG at 1064 nm or 532 nm; Nd:YVO4 at 914, 1064 or 1342 nm; Nd:YLF at 1047 or 1053 nm. Gas and excimer lasers can also be used, as well as semiconductor or fiber lasers. The laser can also match the absorption of transparent oxide layer (if such is used as electrode); it can also match an absorption wavelength of the organic layers.

Preferentially, pulsed lasers are used which make it easier to control the laser power per shot, which shot is forming the electrical connection between top and bottom electrodes.

Since the materials and the number of layers used in an OLED can be changed according to the application, a calibration step of the laser can be provided before the use of the laser in production.

In a preferred embodiment, the step of generating the inter electrode series connections by laser processing comprises a step irradiating laser light through the substrate. In addition or as an alternative, laser light may be irradiated from the top.

According to another embodiment, the method further comprises a step of providing an encapsulation on the top electrode.

In still a further embodiment, the step of providing the series connection of the plurality of organic light emitting diodes is performed after the step of providing the encapsulation. The laser light may be irradiated through the substrate and / or the encapsulation. The inter electrode connection is made by a laser process, again, not requiring vacuum or inert atmosphere.

According to a preferred embodiment, the plurality of organic light emitting diodes is generated on the substrate by a maskless deposition process comprising a step of maskless depositing materials in at least an active area. However, masking, such as a simple frame, may be used to avoid material deposition outside the active area of the device which is provided by the outer perimeter of the organic light emitting diodes. In the area outside the active area a connecting area may be provided.

In another preferred embodiment, the bottom electrode is provided as a transparent bottom electrode. The transparent electrode, for example, can be realized by thin metal layers (range 5-30 nm, e.g. Ag, Au, Al, Cu) or degenerated inorganic semiconductors, usually oxides, like ITO (indium-tin-oxide) of IZO (indium-zinc-oxide). Since the ITO or IZO can not be thermally annealed due to temperature limitations of the underlying OLED, the resistance of an ITO or IZO top electrode is usually above 100 ohm/square.

In a preferred embodiment, the top electrode is provided as a transparent top electrode. Again, the transparent electrode, for example, can be realized by thin metal layers (range 5-30 nm, e.g. Ag, Au, Al, Cu) or degenerated inorganic semiconductors, usually oxides, like ITO (indium-tin-oxide) of IZO (indium-zinc-oxide). Since the ITO or IZO can not be thermally annealed due to temperature limitations of the underlying OLED, the resistance of an ITO or IZO top electrode is usually above 100 ohm/square.

According to a further embodiment, the separator is provided as a tapered separator. In an embodiment, the tapered separator is provided with a mushroom like shape.

In still a further embodiment, the separator is provided with a plurality of sub-separators. As an alternative, the separator may be provided as single piece separator.

According to a preferred embodiment, the inter electrode series connection is provided adjacent to an electrode edge of the bottom electrode, and wherein the separator is provided adjacent to the inter electrode series connection on a side of the inter electrode series connection facing away from the electrode edge. In a preferred embodiment, a distance between the inter electrode series connection and the electrode edge of the bottom electrode is smaller than about 1/10 of one lateral dimension of the emitting area, preferably less than about 1mm, and more preferably less than about 300 µm.

In another preferred embodiment, the organic layer is provided with a redox doped layer adjacent to the top-electrode.

It is further preferred that the layer(s) between the top and bottom electrodes are free of inorganic tunneling layer(s). In exceptional cases such tunneling layers can be provided if they are not closed layers, these non-closed layers have a typical thickness of less than 5 nm, however it is preferred that they are completely avoided. Examples of inorganic tunneling layers are inorganic salt layers such as LiF, NaCs, other examples are inorganic insulators such as SiO₂, silicon nitride, etc. Such layers increase operating voltage of the OLEDs due to their high resistivity. In addition, the process of making such layers is imposing excess energy to the OLED layers eventually leading to degradation of the other materials of the OLED. Such layers are also undesired for the inter electrode connection by laser.

In a preferred embodiment, the layer(s) between the top and bottom electrodes are free of inorganic conducting layer(s). An example of such inorganic conducting layer is a layer of ITO used as intermediate connector or intermediate electrode.

It is further preferred that each single, distinct, organic layer which is thicker than 35 nm is made of a material or material composition with a Tg < 300 °C, preferably lower than 200 °C.

The separation in the other lateral direction than as in the direction of the series connected OLEDs can be done by a normal single non-conductive separator approach, e.g. in shape of a mushroom. Doing so the in series connected OLEDs can be electrically connected in parallel to the next series of serial connected OLEDs.

A typical size of an OLED is in the range of 0,5 cm x 0,5 cm to 3 cm x 3 cm. E.g. with a OLED size of 1 cm x 1 cm and N=10, a roughly 10 x 10 cm² sized large area organic light emitting device can be realized. That means the length of the connector (perpendicular to the connection direction and parallel to the substrate) of the cathode to the next anode is approx. 0,5 to 3 cm long.

Typical layer thicknesses of the organic layers of the OLEDs are about 50 to about 1000 nm, preferably between about 100 nm and about 300 nm, the layer thickness of the ITO bottom electrode is in the range of about 10 to about 500 nm, preferably between about 20 nm and about 200 nm. The non-conductive separator height (resp. thickness) must be larger than the thickness of the layer stack (sum of the thickness of all layers deposited on top of the bottom electrode), in the range of about 500 nm to about 5 µm.

The separator is a non-conductive surface topography which provides the patterning of the layers deposited on top of it, such as organic layer and top conducting layer. The separator forms an in-situ shadow mask, preferably with a rectangular shape, an inverted isosceles trapezoidal shape, or a mushroom shape. It is preferred that the end of the separator which is distant from the substrate is larger than the end which is closer to the substrate. The separator is preferably made by a positive or a negative photoresist, or by using a two layer positive / negative photoresist. The separator is preferably made by photolithography. Alternative methods for deposition of the separator can be used, for example screen printing.

The height of separator (normal to the direction of the substrate) is greater than the sum of the thickness of the organic layer and the thickness of the top conducting layer, preferably 5 times greater, more preferably 10 times greater.

### Description of preferred embodiments

Following the invention will be described in further detail, by way of example, with reference to different embodiments. In the figures show:
- Fig. 1: a bottom emitting organic light emitting device comprising a plurality of series connected light emitting organic diodes (OLEDs) according to the prior art,
- Fig. 2: a bottom emitting device,
- Fig. 3: a top-emitting device,
- Fig. 4: a transparent device,
- Fig. 5: a top view of an array of series connected OLEDs according to the invention.
- Fig. 6: an alternative connection pattern for a large area organic light emitting device,
- Fig. 7: in detail a preferred mode for the insulating separator and
- Fig. 8: an embodiment for an inter electrode connection.

Fig. 1 shows a bottom emitting organic light emitting device comprising of series connected OLEDs according to the prior art. Fig.1 shows a layered structure over a transparent substrate 10, comprising a transparent bottom electrode 11, at least one organic semiconducting layer 12, and a reflective top electrode 13. The at least one organic semiconducting layer 12 and the top electrode 13 need to be directly patterned by e.g. shadow masks or ink-jet printing.

Fig. 2 shows a bottom emitting device comprising a pre-patterned bottom electrode 21 and an electrically insulating separator 25 over a substrate 20. Organic layer(s) 22 and a top electrode 23 are produced without shadow masks. The separation of the individual OLEDs is provided by the electrically insulating separators 25 during deposition of the layers. An inter electrode series connection 24 which may also referred to as an electrical top-electrode-bottom-electrode connection is made by a laser process.

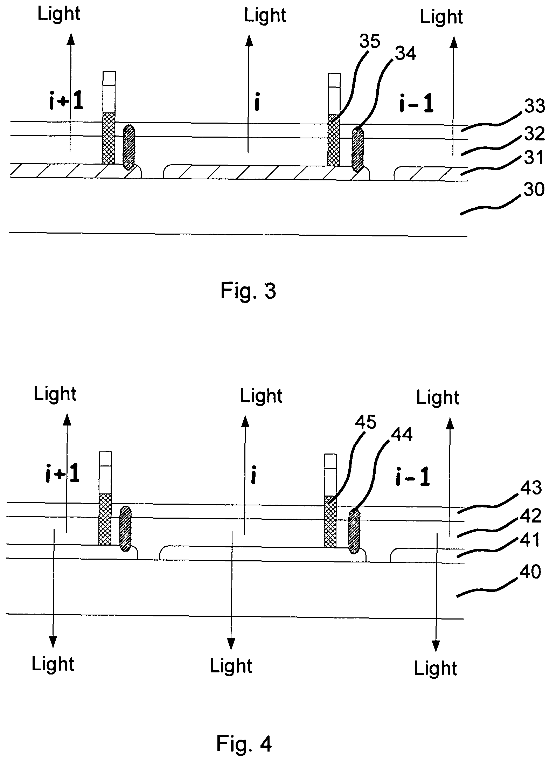

Fig. 3 shows a top emitting device with a layered structure comprising a bottom electrode 31 over a substrate 30, at least one organic semiconducting layer 32 between the bottom electrode 31 and a top electrode 33, wherein the top electrode 33 is transparent and the substrate 30 and / or the bottom electrode 31 are reflective. The separation of the individual OLEDs is provided by electrically insulating separators 35 during deposition of the layers. An inter electrode series connection 34 is made by laser.

Fig. 4 shows a transparent device with at least one organic semiconducting layer 42 in between electrodes 41 and 43, wherein the top electrode 43, the bottom electrode 41, and a substrate 40 are transparent. An insulating separator 45 and the inter electrode series connection 44 provide the series connection of individual OLEDs (i+1, i, i-1, ...).

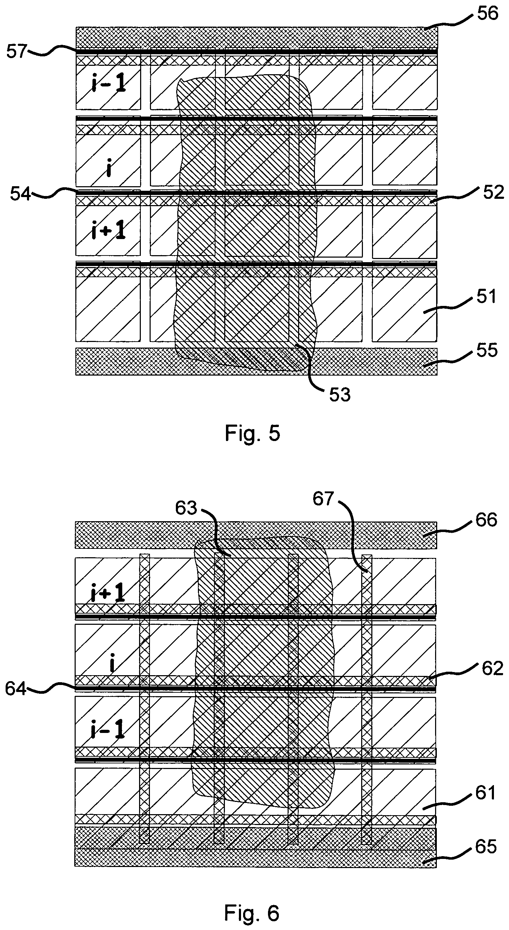

Fig. 5 shows an array of series (column ..., i-1, i, i+1) connected OLEDs, which columns are connected in parallel (rows). Fig. 5 shows patterned bottom electrodes 51, an insulating separator 52, and an inter electrode series connection 54. The black lines (54) show where the laser is applied, obviously the inter electrode connection is formed only where top and bottom electrodes are provided. The columns can be connected in parallel by conducting layers 55 and 56. Alternatively the columns can be driven in groups or individually. Alternatively or in addition, the layer forming the bottom electrodes can be patterned to be continuous between adjacent columns. The bottom electrodes of a row can optionally be use single layer (e.g. a strip). A layer 53 which also provides the top electrode is only showed partially (for clarity reasons).

The layer 56 is provided on top and in electrical contact to the bottom electrodes before the deposition of the organic layers. Alternatively or optionally, an optional interconnection 57 can be used to provided the inter connection between conductive layer 56 and bottom electrodes. Other variations can be made, for example the conductive layer 56 does not overlap with the bottom electrodes, and the top conductive layer which also forms the top electrodes, plus the required interconnection, provides the necessary electrical path. Equivalent thinking can be applied to the conductive layer 55 and to other embodiments. The conductive layer 55 can, optionally, be an extension of the top electrode layer, and be provided over the organic layer (this also applies to the other embodiments).

Fig. 6 shows an array of series (column ..., i-1, i, i+1) connected OLEDs, which columns are connected in parallel (rows). Fig. 6 shows patterned bottom electrodes 61, an insulating separator 62, and an inter electrode series connection 64. The columns can be connected in parallel by conducting layers 65 and 66. A layer 63 which also provides the top electrode is only showed partially (for clarity reasons). In this embodiment the insulating separator 62 is patterned in the areas 62 and 67, wherein the areas 67 (parallel to the columns) are used to define emitting areas. Alternatively or in addition, the layer forming the bottom electrodes 61 can be patterned to be continuous between adjacent columns. The bottom electrodes 61 of a row can optionally be a single layer (e.g. a strip).

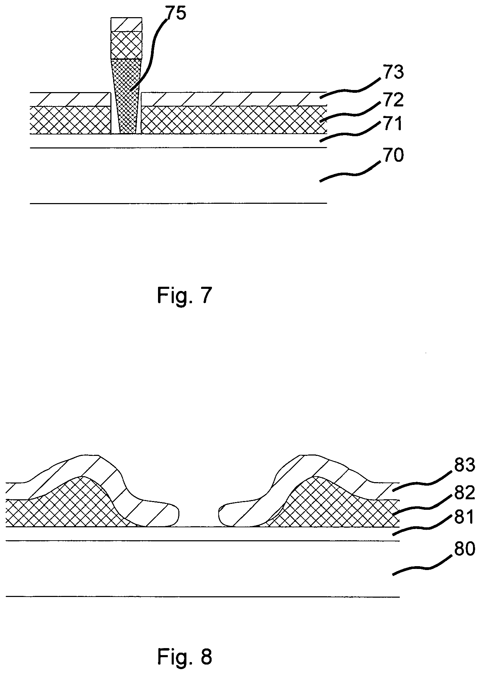

Fig. 7 shows a layered structure comprising a substrate 70, a bottom electrode 71, at least one organic layer 72, and a top electrode 73. An insulating separator 75 is used to separate the at least one organic layer 72 and the top electrode 73 into two regions. The insulating separator 75 has preferentially a cone (mushroom) format. This can be realized by constructing the insulating separator 75 from two photoresist with different etching speed (the lower part must have higher etching speed).

Fig. 8 shows a mode for the inter electrode connection. Fig. 8 shows a layered structure comprising a substrate 80, a bottom electrode 81, at least one organic layer 82, and a top electrode 83. After fabricating the inter electrode connection by laser method as described above, the top electrode is in direct contact to the bottom electrode. The layer forming the top electrode does not necessarily need to be interrupted as shown in Fig. 8.

Following further embodiments are described by reference to device examples.

The following terms are used: Spiro-TTB - octap-tolyl-9,9'-spirobi[fluorene]-2,2',7,7'-tetraamine-2,2',7,7'-tetrakis(N,N-di-p-methylphenylamino)-9,9'-spirobifluorene, F4TCNQ - 2,3,5,6-Tetrafluor-7,7,8,8-tetracyanochinodimethan, Spiro-TAD - 2,2',7,7'-Tetrakis(N,N-diphenylamino)-9,9'-spirobifluorene, Ir(ppy)3 - tris(2-phenylpyridine) iridium, TPBI - 1,3,5-Tris(1-phenyl-1H-benzimidazol-2-yl)benzene und BPhen - 2,9-Bis(naphthalen-2-yl)-4,7-diphenyl-1,10-phenanthroline.

A 0,8 mm thick glass substrate, with lateral dimensions of 100 mm x 100 mm, was provided as substrate. The glass substrate contains a pre-patterned ITO layer, patterned into 8 strips with lateral dimensions of 80 mm x 9,5 mm, spaced apart by 500 µm, except for the first strip which has an elongation to the edge (A) of the substrate which is used to supply electrical power to the device.

A 2,3 µm thick photo definable polyimide layer (HD-8820 from HD microsystems) was deposited on the substrate by spin coating. The polyimide layer is heated at 120 °C for 3 minutes; the insulating separator is defined by exposing the polyimide layer to a light pattern for 50 seconds, developing for 120 seconds and heating at 180 °C for half an hour. The insulating separators are provided at 300 µm away from one edge of each patterned ITO strip. The area of 300 µm, between the insulating separator and the edge, is used for the top-electrode-bottom-electrode connection. The insulating separators are provided as 7 lines with a length of 82 mm.

The stack of organic semiconducting layers was deposited by vacuum evaporation, over an area of 82 mm x 82 mm completely covering the ITO strips, except for the first strip which has an elongation to the edge of the substrate which is used to supply electrical power to the device. The stack of organic layers was made with the following layers:
- a hole transporting layer: 78 nm of Spiro-TTB, p-doped with 2mol% of F4TCNQ,
- an electron transport layer: 10 nm of Spiro-TAD,
- an emitter layer 1, 5 nm of Spiro-TAD doped with 5mol% of Ir(ppy)3,
- an emitter layer 2, 10 nm of TPBI doped with 9mol% of Ir(ppy)3,
- an electron transport layer, 10 nm of BPhen, and
- an electron transport layer, 30 nm of BPhen doped with Cs (molar ratio 1:1).

A top electrode of 100 nm Al was deposited over an area of 80 mm x 90 mm, overlapping the ITO strips and extending to the edge of the substrate, which edge is opposite to the edge (A), providing an external electrical supply layer.

The top electrode was interrupted by the insulating separators on the desired positions, electrically isolating the individual devices.

The device was encapsulated using a rigid glass encapsulation cover glued to the glass substrate; the encapsulation also comprised an oxygen and moisture getter.

The electrical top-electrode-bottom-electrode connection was formed by applying laser pulses on the edge of the ITO stripes forming 7 rows, between the insulating separator and the edge of the ITO stripes, forming the electrical connection in series. The laser used in this example was a pulsed Nd:YAG laser operating at 1064 nm. The laser process was done in air, because the device was encapsulated. It could also been done in inert atmosphere, before the encapsulation, which would, however increase process complexity.

The laser pulses where applied trough the encapsulation, however, it could also be applied trough the substrate.

The organic light emitting device worked as expected, having eight single light emitting diodes connected in series.

The example above was repeated, with the insulating separator provided at a distance of 100 µm of the edge of the ITO strip. The inter electrode connection was formed on these 100 µm wide and 80 mm long area. With this method, not only the process is strongly simplified, but the connection area can be minimized. Even gaps between the ITO strips, as small as 100 µm can be used, decreasing the total dead area (area used for the connection, which do not emit light) to less than 300 µm.

The features disclosed in this specification, claims and / or the figures may be material for the realization of the invention in its various embodiments, taken in isolation or in various combinations thereof.

## Claims

1. A method for producing an organic light emitting device, especially a large area organic light emitting device, the method comprising steps of:
- providing a plurality of organic light emitting diodes on a substrate (20; 30; 40; 70; 80), wherein the step of providing the plurality of organic light emitting diodes comprises steps of:
- providing a bottom electrode (21; 31; 41; 71; 81) for each of the plurality of organic light emitting diodes by depositing a patterned bottom conductive layer on the substrate (20; 30; 40; 70; 80);
- providing a separator (25; 35; 45; 55; 65; 75) on the bottom conductive layer,
- providing at least one organic layer (22; 33; 42; 72; 82) for each of the plurality of organic light emitting diodes on the bottom conductive layer, and
- providing a top electrode (23; 33; 43; 73; 83) for each of the plurality of organic light emitting diodes by depositing a top conductive layer on the at least one organic layer (22; 33; 42; 72; 82), top electrodes (20; 30; 40; 70; 80) of adjacent organic light emitting diodes being separated by the separator (25; 35; 45; 55; 65; 75),
and
- providing a series connection of the plurality of organic light emitting diodes, wherein the step of providing the series connection comprises steps of:
- generating inter electrode series connections (24; 34; 44) in a connection area,
- providing each of the inter electrode series connections (24; 34; 44) by electrically connecting, via the at least one organic layer (22; 33; 42; 72; 82), a top electrode (23; 33; 43; 73; 83) and a bottom electrode (21; 31; 41; 71; 81) of adjacent organic light emitting diodes of the plurality of organic light emitting diodes, and
- via the at least one organic layer (22; 33; 42; 72; 82), generating the inter electrode series connections (24; 34; 44) in a laser process by irradiating a laser light into the connection area in which the inter electrode series connection (24; 34; 44) is to be formed.

2. Method according to claim 1, wherein the step of generating the inter electrode series connections (24; 34; 44) by laser processing comprises a step irradiating laser light through the substrate (20; 30; 40; 70; 80).

3. Method according to claim 1 or 2, the method further comprising a step of providing an encapsulation on the top electrode (23; 33; 43; 73; 83).

4. Method according to claim 3, wherein the step of providing the series connection of the plurality of organic light emitting diodes is performed after the step of providing the encapsulation.

5. Method according to at least one of the preceding claims, wherein the plurality of organic light emitting diodes is generated on the substrate (20; 30; 40; 70; 80) by a maskless deposition process comprising a step of maskless depositing materials in at least an active area.

6. Method according to at least one of the preceding claims, wherein the bottom electrode is provided as a transparent bottom electrode (21; 31; 41; 71; 81).

7. Method according to at least one of the preceding claims, wherein the top electrode (23; 33; 43; 73; 83) is provided as a transparent top electrode.

8. Method according to at least one of the preceding claims, wherein the separator (25; 35; 45; 55; 65; 75) is provided as a tapered separator.

9. Method according to at least one of the preceding claims, wherein the separator (25; 35; 45; 55; 65; 75) is provided with a plurality of sub-separators.

10. Method according to at least one of the preceding claims, wherein the inter electrode series connection (24; 34; 44) is provided adjacent to an electrode edge of the bottom electrode (21; 31; 41; 71; 81), and wherein the separator (25; 35; 45; 55; 65; 75) is provided adjacent to the inter electrode series connection (24; 34; 44) on a side of the inter electrode series connection facing away from the electrode edge.

11. Method according to at least one of the preceding claims, wherein the organic layer is provided with a redox doped layer adjacent to the top-electrode (23; 33; 43; 73; 83).

## Patentansprüche

1. Verfahren zum Herstellen einer organischen lichtemittierenden Vorrichtung, insbesondere einer großflächigen organischen lichtemittierenden Vorrichtung, wobei das Verfahren Folgendes umfasst:
- Bereitstellen mehrerer organischer lichtemittierender Dioden auf einem Substrat (20; 30; 40; 70; 80), wobei das Bereitstellen der mehreren organischen lichtemittierenden Dioden die folgenden Schritte umfasst:
- Bereitstellen einer Bodenelektrode (21; 31; 41; 71; 81) für jede der mehreren organischen lichtemittierenden Dioden durch Abscheiden einer strukturierten leitfähigen unteren Schicht auf dem Substrat (20; 30; 40; 70; 80);
- Bereitstellen eines Trennelements (25; 35; 45; 55; 65; 75) auf der leitfähigen unteren Schicht,
- Bereitstellen von mindestens einer organischen Schicht (22; 33; 42; 72; 82) für jede der mehreren organischen lichtemittierenden Dioden auf der leitfähigen unteren Schicht, und
- Bereitstellen einer oberen Elektrode (23; 33; 43; 73; 83) für jede der mehreren organischen lichtemittierenden Dioden durch Abscheiden einer oberen leitfähigen Schicht auf der mindestens einen organischen Schicht (22; 33; 42; 72; 82), wobei die oberen Elektroden (20; 30; 40; 70; 80) der benachbarten organischen lichtemittierenden Dioden durch das Trennelement (25; 35; 45; 55; 65; 75) getrennt werden,
und
- Bereitstellen einer Reihenschaltung der mehreren organischen lichtemittierenden Dioden, wobei das Bereitstellen der Reihenschaltung die folgenden Schritte umfasst:
- Erzeugen von Reihenschaltungen (24; 34; 44) in einem Schaltungsbereich,
- Bereitstellen von jeder der Reihenschaltungen (24; 34; 44) durch elektrisches Verbinden einer oberen Elektrode (23; 33; 43; 73; 83) und einer unteren Elektrode (21; 31; 41; 71; 81) von benachbarten organischen lichtemittierenden Dioden der mehreren organischen lichtemittierenden Dioden über die mindestens eine organische Schicht (22; 33; 42; 72; 82), und
- über die mindestens eine organische Schicht (22; 33; 42; 72; 82) Erzeugen der Reihenschaltungen (24; 34; 44) zwischen den Elektroden in einem Laserprozess mittels Einstrahlen von Laserlicht in den Schaltungsbereich, in dem die Reihenschaltung (24; 34; 44) zwischen den Elektroden gebildet werden soll.

2. Verfahren nach Anspruch 1, wobei das Erzeugen der Reihenschaltungen (24; 34; 44) zwischen den Elektroden mittels Laserbearbeitung den Schritt des Einstrahlens von Laserlicht durch das Substrat (20; 30; 40; 70; 80) umfasst.

3. Verfahren nach Anspruch 1 oder 2, wobei das Verfahren ferner ein Bereitstellen einer Verkapselung auf der oberen Elektrode (23; 33; 43; 73; 83) umfasst.

4. Verfahren nach Anspruch 3, wobei das Bereitstellen der Reihenschaltung der mehreren organischen lichtemittierenden Dioden nach dem Bereitstellen der Verkapselung vorgenommen wird.

5. Verfahren nach einem der vorherigen Ansprüche, wobei die mehreren organischen lichtemittierenden Dioden auf dem Substrat (20; 30; 40; 70; 80) durch einen maskenfreien Abscheidungsprozess erzeugt werden, der eine maskenfreie Abscheidung von Materialien in mindestens einem aktiven Bereich umfasst.

6. Verfahren nach mindestens einem der vorherigen Ansprüche, wobei die untere Elektrode als transparente untere Elektrode (21; 31; 41; 71; 81) gebildet ist.

7. Verfahren nach mindestens einem der vorherigen Ansprüche, wobei die obere Elektrode (23; 33; 43; 73; 83) als transparente obere Elektrode gebildet ist.

8. Verfahren nach mindestens einem der vorherigen Ansprüche, wobei das Trennelement (25; 35; 45; 55; 65; 75) als spitz zulaufendes Trennelement gebildet ist.

9. Verfahren nach mindestens einem der vorherigen Ansprüche, wobei das Trennelement (25; 35; 45; 55; 65; 75) mit mehreren Teiltrennelementen gebildet ist.

10. Verfahren nach mindestens einem der vorherigen Ansprüche, wobei die Reihenschaltung (24; 34; 44) zwischen den Elektroden angrenzend an eine Elektrodenkante der unteren Elektrode (21; 31; 41; 71; 81) vorgesehen ist und wobei das Trennelement (25; 35; 45; 55; 65; 75) angrenzend an die Reihenschaltung (24; 34; 44) zwischen den Elektroden auf einer Seite der Reihenschaltung zwischen den Elektroden von der Elektrodenkante abgewandt angeordnet ist.

11. Verfahren nach mindestens einem der vorherigen Ansprüche, wobei die organische Schicht mit einer redox-dotierten Schicht angrenzend an die obere Elektrode (23; 33; 43; 73; 83) angeordnet ist.

## Revendications

1. Procédé pour la production d'un dispositif électroluminescent organique, en particulier un dispositif électroluminescent organique de grande surface, le procédé comprenant les étapes suivantes :
- la mise à disposition d'une pluralité de diodes électroluminescentes organiques sur un substrat (20 ; 30 ; 40 ; 70 ; 80), l'étape de mise à disposition de la pluralité de diodes électroluminescentes organiques comprenant les étapes suivantes :
- la mise à disposition d'une électrode inférieure (21 ; 31 ; 41 ; 71 ; 81) pour chacune de la pluralité de diodes électroluminescentes organiques par dépôt d'une couche conductrice inférieure structurée sur le substrat (20 ; 30 ; 40 ; 70 ; 80) ;
- la mise à disposition d'un séparateur (25 ; 35 ; 45 ; 55 ; 65 ; 75) sur la couche conductrice inférieure,
- la mise à disposition d'au moins une couche organique (22 ; 33 ; 42 ; 72 ; 82) pour chacune de la pluralité de diodes électroluminescentes organiques sur la couche conductrice inférieure, et
- la mise à disposition d'une électrode supérieure (23 ; 33 ; 43 ; 73 ; 83) pour chacune de la pluralité de diodes électroluminescentes organiques par dépôt d'une couche conductrice supérieure sur l'au moins une couche organique (22 ; 33 ; 42 ; 72 ; 82), des électrodes supérieures (20 ; 30 ; 40 ; 70 ; 80) de diodes électroluminescentes organiques adjacentes étant séparées par le séparateur (25 ; 35 ; 45 ; 55 ; 65 ; 75),
et
- la mise à disposition d'une connexion en série de la pluralité de diodes électroluminescentes organiques, l'étape de mise à disposition d'une connexion en série comprenant les étapes suivantes :
- la génération de connexions inter-électrodes en série (24 ; 34 ; 44) dans une zone de connexion,
- la mise à disposition de chaque connexion inter-électrodes en série (24 ; 34 ; 44) en reliant électriquement, par le biais de l'au moins une couche organique (22 ; 33 ; 42 ; 72 ; 82), une électrode supérieure (23 ; 33 ; 43 ; 73 ; 83) et une électrode inférieure (21 ; 31 ; 41 ; 71 ; 81) de diodes électroluminescentes organiques adjacentes de la pluralité de diodes électroluminescentes organiques, et
- par le biais de l'au moins une couche organique (22 ; 33 ; 42 ; 72 ; 82), la génération des connexions inter-électrodes en série (24 ; 34 ; 44) au cours d'un processus laser en irradiant une lumière laser dans la zone de connexion dans laquelle la connexion inter-électrodes en série (24 ; 34 ; 44) est formée.

2. Procédé selon la revendication 1, dans lequel l'étape de génération de connexions inter-électrodes en série (24 ; 34 ; 44) par un processus laser comprend une étape d'irradiation de lumière laser à travers le substrat (20 ; 30 ; 40 ; 70 ; 80).

3. Procédé selon la revendication 1 ou 2, le procédé comprenant en outre une étape de moyen de suppression de rétroaction d'une encapsulation sur l'électrode supérieure (23 ; 33 ; 43 ; 73 ; 83).

4. Procédé selon la revendication 3, dans lequel l'étape de mise à disposition de la connexion en série de la pluralité de diodes électroluminescentes organiques est réalisée après l'étape de mise à disposition de l'encapsulation.

5. Procédé selon l'une au moins des revendications précédentes, dans lequel la pluralité de diodes électroluminescentes organiques est générée sur le substrat (20 ; 30 ; 40 ; 70 ; 80) par un processus de dépôt sans masque comprenant une étape de dépôt de matériaux sans masque dans au moins une zone active.

6. Procédé selon l'une au moins des revendications précédentes, dans lequel l'électrode inférieure est fournie en tant qu'électrode inférieure transparente (21 ; 31 ; 41 ; 71 ; 81).

7. Procédé selon l'une au moins des revendications précédentes, dans lequel l'électrode supérieure (23 ; 33 ; 43 ; 73 ; 83) est mise à disposition en tant qu'électrode supérieure transparente.

8. Procédé selon l'une au moins des revendications précédentes, dans lequel le séparateur (25 ; 35 ; 45 ; 55 ; 65 ; 75) est mis à disposition en tant que séparateur conique.

9. Procédé selon l'une au moins des revendications précédentes, dans lequel le séparateur (25 ; 35 ; 45 ; 55 ; 65 ; 75) est mis à disposition avec une pluralité de sous-séparateurs.

10. Procédé selon l'une au moins des revendications précédentes, dans lequel la connexion inter-électrodes en série (24 ; 34 ; 44) est mise à disposition à côté d'un bord d'électrode de l'électrode inférieure (21 ; 31 ; 41 ; 71 ; 81), et dans lequel le séparateur (25 ; 35 ; 45 ; 55 ; 65 ; 75) est mis à disposition à côté de la connexion inter-électrodes en série (24 ; 34 ; 44) sur un côté de la connexion inter-électrodes en série opposé du bord d'électrode.

11. Procédé selon l'une au moins des revendications précédentes, dans lequel la couche organique est mise à disposition avec une couche dopée au redox à côté de l'électrode supérieure (23 ; 33 ; 43 ; 73 ; 83).
